# EUROPEAN PATENT APPLICATION

(11) **EP 4 764 580 A1**
(43) Date of publication of application: **24.06.2026**
(21) Application number: 24889222.6
(22) Date of filing: 05.08.2024
(51) Int. Cl.: G01R 35/00, G01R 31/385, G01R 19/145, G01R 19/165, G01R 15/14, G01R 31/52, G01R 31/36, B60L 58/16

(54) **CURRENT SENSOR DIAGNOSIS DEVICE, CURRENT SENSOR DIAGNOSIS METHOD, AND CURRENT SENSOR DIAGNOSIS SYSTEM**

(30) Priority: 07.11.2023 KR 20230153128
(71) Applicant: LG Energy Solution, Ltd., Seoul 07335 (KR)
(72) Inventor: MOON, Cheoul Woo, Daejeon 34122 (KR)
(74) Representative: Plasseraud IP
(86) International application number: PCT/KR2024/095985
(87) International publication number: WO 2025/101036

(57) **Abstract**

According to some embodiments disclosed herein, a current sensor diagnosis device includes a voltage sensor configured to collect voltage data of a battery, and a controller configured to determine whether a current flows in the battery based on current data of the battery, which is collected by a current sensor, specify a reference voltage at a first end time point of a first time section based on the voltage data when it is determined that the current does not flow in the battery during the first time section, and diagnose a state of the current sensor based on the reference voltage and the voltage data after the first end time point.

## Description

### TECHNICAL FIELD

### CROSS-REFERENCE TO RELATED APPLICATION

This application claims priority to and the benefit of Korean Patent Application No. 10-2023-0153128 filed in the Korean Intellectual Property Office on November 7, 2023, the entire contents of which are incorporated herein by reference.

### TECHNICAL FIELD

Embodiments disclosed therein relate to a current sensor diagnosis device, a current sensor diagnosing method, and a current sensor diagnosis system.

### BACKGROUND ART

Recently, research and development on secondary batteries has been actively conducted. Here, the secondary battery is a battery capable of charging and discharging and may be construed as including all conventional Ni/Cd batteries and Ni/MH batteries and recent lithium ion batteries. Among secondary batteries, lithium ion batteries may have a higher energy density than conventional Ni/Cd batteries, Ni/MH batteries, etc. and may be manufactured in a compact and lightweight manner, and thus may have high usability in terms of power sources for mobile devices. Recently, the lithium-ion batteries are attracting attention as a next-generation energy storage medium as a range of use expands to a power source for an electric vehicle.

A current sensor may be used to measure a charging current or discharging current of a battery. For example, a mobility device such as an electric bike may include a battery and a current sensor, in which the current sensor may collect current data from the battery, and various management functions for the battery may be performed based on the current data. Meanwhile, when there is a problem with the current sensor, the reliability of the current data may be degraded, and the results of battery diagnosis may be affected.

### DISCLOSURE

### TECHNICAL PROBLEM

Embodiments disclosed herein are directed to providing a current sensor diagnosis device, a current sensor diagnosing method, and a current sensor diagnosis system, which may diagnose whether there is a problem with a current sensor.

The technical objects of embodiments disclosed herein are not limited to the above-described objects, and other objects that are not described will be able to be clearly understood by those skilled in the art from the following descriptions.

### TECHNICAL SOLUTION

According to some embodiments disclosed herein, a current sensor diagnosis device includes a voltage sensor configured to collect voltage data of a battery, and a controller configured to determine whether a current flows in the battery based on current data of the battery, which is collected by a current sensor, specify a reference voltage at a first end time point of a first time section based on whether the current flows in the battery during the first time section and the voltage data, and diagnose a state of the current sensor based on the reference voltage and the voltage data after the first end time point.

According to some embodiments, the controller is configured to determine whether the current flows in the battery after the first end time point based on the current data, and correct the state of the current sensor based on whether the current flows in the battery after the first end time point.

According to some embodiments, when it is determined that the current flows in the battery after the first end time point, the controller is configured to determine that charging or discharging of the battery has been temporarily stopped during the first time section.

According to some embodiments, the controller is configured to specify a comparison voltage at a second end time point of the second time section when it is determined that the current does not flow in the battery during a second time section after the end time point, and diagnose whether the current sensor fails based on a difference between the reference voltage and the comparison voltage.

According to some embodiments, the controller is configured to specify an additional voltage of the battery at a measurement period immediately after the second end time point based on the voltage data when the difference between the reference voltage and the comparison voltage exceeds a threshold value, and diagnose the state of the current sensor as a failure when a difference between the additional voltage and the comparison voltage exceeds the threshold value.

According to some embodiments, the controller is further configured to inform a user of the battery of a failure of the current sensor when the state of the current sensor is diagnosed as a failure, and open a relay configured to open and close connection of the battery.

According to some embodiments, the battery and the current sensor are mounted on a mobility device driven using electrical energy, and the battery is charged or discharged by the mobility device.

According to some embodiments, the current sensor includes a shunt resistor sensor configured to measure a current using a shunt resistor, and a failure of the current sensor includes a failure that it is determined that the shunt resistor is shorted.

According to some embodiments disclosed herein, a current sensor diagnosing method includes collecting voltage data of a battery, determining whether a current flows in the battery based on current data of the battery, which is collected by a current sensor, specifying a reference voltage at a first end time point of a first time section based on whether the current flows in the battery during a first time section and the voltage data, and diagnosing a state of the current sensor based on the reference voltage and the voltage data after the first end time point.

According to some embodiments, the diagnosing of the state of the current sensor includes determining whether the current flows in the battery after the first end time point based on the current data, and correcting the state of the current sensor based on whether the current flows in the battery after the first end time point.

According to some embodiments, the correcting of the state of the current sensor includes determining that charging or discharging of the battery has been temporarily stopped during the first time section when it is determined that the current flows in the battery after the first end time point.

According to some embodiments, the diagnosing of the state of the current sensor includes specifying a comparison voltage at a second end time point of the second time section when it is determined that the current does not flow in the battery during a second time section after the end time point, and diagnosing whether the current sensor fails based on a difference between the reference voltage and the comparison voltage.

According to some embodiments, the diagnosing of the state of the current sensor includes specifying an additional voltage of the battery at a measurement period immediately after the second end time point based on the voltage data when the difference between the reference voltage and the comparison voltage exceeds a threshold value, and diagnosing the state of the current sensor as a failure when a difference between the additional voltage and the comparison voltage exceeds the threshold value.

According to some embodiments, the current sensor diagnosing method further includes informing a user of the battery of a failure of the current sensor when the state of the current sensor is diagnosed as a failure, and opening a relay configured to open and close connection of the battery.

According to some embodiments, the battery and the current sensor are mounted on a mobility device driven using electrical energy, and the battery is charged or discharged by the mobility device.

According to some embodiments, the current sensor includes a shunt resistor sensor configured to measure a current using a shunt resistor, and a failure of the current sensor includes a failure that it is determined that the shunt resistor is shorted.

According to some embodiments disclosed herein, a current sensor diagnosis system includes a battery, a current sensor configured to collect current data of the battery, and a current sensor diagnosis device configured to collect voltage data of the battery, determine whether a current flows in the battery based on the current data, specify a reference voltage at a first end time point of a first time section based on whether the current flows in the battery during the first time section and the voltage data, and diagnose a state of the current sensor based on the reference voltage and the voltage data after the first end time point.

According to some embodiments, the current sensor diagnosis device is configured to determine whether the current flows in the battery after the first end time point based on the current data, and correct the state of the current sensor based on whether the current flows in the battery after the first end time point.

According to some embodiments, when it is determined that the current flows in the battery after the first end time point, the current sensor diagnosis device is configured to determine that charging or discharging of the battery has been temporarily stopped during the first time section.

According to some embodiments, the current sensor diagnosis device is configured to specify a comparison voltage at a second end time point of the second time section when it is determined that the current does not flow in the battery during a second time section after the end time point, and diagnose whether the current sensor fails based on a difference between the reference voltage and the comparison voltage.

### ADVANTAGEOUS EFFECTS

According to the embodiments disclosed herein, it is possible to provide the current sensor diagnosis device, the current sensor diagnosing method, and the current sensor diagnosis system, which may diagnose whether there is a problem with the current sensor.

The technical effects according to the embodiments disclosed herein are not limited to the above-described effects, and other effects that are not described will be able to be clearly understood by those skilled in the art according to the disclosure of the present document.

### DESCRIPTION OF DRAWINGS

FIG. 1 may show elements constituting a current sensor diagnosis system according to some embodiments.
FIG. 2 may show elements constituting a current sensor diagnosis device according to some embodiments.
FIG. 3 may show a structure for diagnosing a state of a current sensor in the current sensor diagnosis system according to some embodiments.
FIG. 4 may show a shunt resistor structure of the current sensor according to some embodiments.
FIG. 5 may show an aspect in which a voltage value, a current value, and a voltage difference value are changed when a shunt resistor of the current sensor is shorted according to some embodiments.
FIGS. 6 to 8 may show an algorithm for diagnosing a failure of the current sensor due to the short of the shunt resistor according to some embodiments.
FIG. 9 may show operations constituting a current sensor diagnosing method according to some embodiments.

### MODE FOR INVENTION

Hereinafter, embodiments disclosed herein will be described with reference to the accompanying drawings. However, it should be understood that this is not intended to limit the disclosure of the present document to specific embodiments and includes various modifications, equivalents, and/or alternatives of the embodiments described herein.

It should be understood that the embodiments of the present document and the terms used herein are not intended to limit the technical features described herein to specific embodiments and include various modifications, equivalents, or substitutes of the corresponding embodiments. In the description of the drawings, similar reference numerals may be used for similar or related components. The singular form of a noun corresponding to an item may include one item or a plurality of items unless the relevant context clearly dictates otherwise.

In the present document, each of phrases such as "A or B," "at least one of A and B," "at least one of A or B," "A, B, or C," "at least one of A, B, and C," and "at least one of A, B, or C" may include any one of the items listed together in the corresponding phrase among these phrases or all possible combinations thereof. Terms such as "1st," "2nd," "first," "second," "A," "B," "(a)," or "(b)" may simply be used to distinguish the corresponding component from another and do not limit the corresponding components in another aspect (e.g., importance or order).

In the present document, when a certain (e.g., a first) component is described as being "coupled," "connected," or "joined" to another (e.g., a second) component with or without the terms "functionally" or "communicatively" or "coupled" or "connected," this means that the certain component may be connected to another component directly (e.g., in a wired or wireless manner) or indirectly (e.g., through a third component).

A method according to various embodiments disclosed herein may be provided by being included in a computer program product. The computer program product may be traded between sellers and buyers as commodities. The computer program product may be distributed in the form of a device-readable storage medium (e.g., a compact disc read only memory (CD-ROM)) or distributed (e.g., downloaded or uploaded) through application stores or directly online between two user devices. In the case of the online distribution, at least some of the computer program products may be at least temporarily stored or temporarily generated in a device-readable storage medium such as a memory of a server of a manufacturer, a server of an application store, or a relay server.

According to the embodiments disclosed herein, each component (e.g., a module or program) of the above-described components may include a single object or a plurality of objects, and some of the plurality of objects may be separately disposed in another component. According to the embodiments disclosed herein, one or more of the above-described corresponding components or operations may be omitted, or one or more other components or operations may be added. Alternatively or additionally, the plurality of components (e.g., modules or programs) may be integrated into one component. In this case, the integrated component may perform one or more functions of each of the plurality of components identically or similarly to those performed by the corresponding component of the plurality of components before the integration. According to the embodiments disclosed herein, operations performed by modules, programs, or other components may be executed sequentially, in parallel, repeatedly, or heuristically, or one or more of the operations may be executed in a different order or omitted, or one or more other operations may be added.

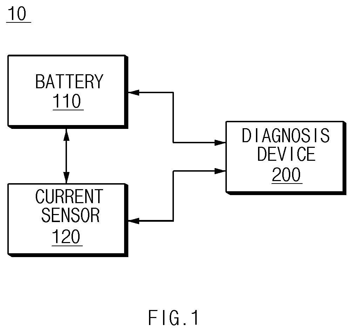

FIG. 1 may show elements constituting a current sensor diagnosis system according to some embodiments.

Referring to FIG. 1, a diagnosis system 10 may include a battery 110, a current sensor 120, and a diagnosis device 200. However, the embodiments are not limited thereto, and some components may be omitted from the diagnosis system 10, or other general-purpose components may be further included in the diagnosis system 10.

The diagnosis system 10 may include a current sensor diagnosis system for diagnosing the current sensor 120 for measuring an input current or output current of the battery 110. When the battery 110 is charged or discharged, the current sensor 120 may measure current data of the battery 110, and the diagnosis device 200 may diagnose whether the current sensor 120 operates normally.

The battery 110 may include one or more battery packs. Each battery pack of the battery 110 may include a plurality of battery modules, and each battery module may include a plurality of battery cells. According to an embodiment, the battery 110 may be mounted on a power usage device 100 and discharged or charged by the power usage device 100.

The current sensor 120 may include a means for measuring a current of the battery 110. According to an embodiment, the current sensor 120 may include a shunt resistor sensor for measuring a current using a shunt resistor. According to an embodiment, the current sensor 120 may be mounted on the power usage device 100 together with the battery 110. Alternatively, the current sensor 120 may be configured integrally with the diagnosis device 200.

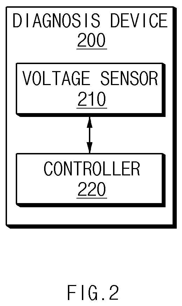

FIG. 2 may show elements constituting a current sensor diagnosis device according to some embodiments.

Referring to FIG. 2, the diagnosis device 200 may include a voltage sensor 210 and a controller 220. However, the embodiments are not limited thereto, and some components may be omitted from the diagnosis device 200, or other general-purpose components may be further included in the diagnosis device 200. As described above, the diagnosis device 200 may include a current sensor diagnosis device configured to diagnose a state of the current sensor 120.

According to an embodiment, the voltage sensor 210 and the controller 220 in the diagnosis device 200 may be electrically connected through a device-to-device communication method. The device-to-device communication method may include a bus, a general purpose input and output (GPIO), a serial peripheral interface (SPI), a mobile industry processor interface (MIPI), etc.

The voltage sensor 210 may include a means for measuring a voltage of the battery 110. For example, the voltage sensor 210 may measure a cell voltage, module voltage, pack voltage, etc. of the battery 110. The diagnosis device 200 may further include a temperature sensor for measuring a temperature of the battery 110, etc. in addition to the voltage sensor 210.

The controller 220 may have a structure for executing commands that implement operations of the diagnosis device 200. The controller 220 may be implemented as an array of a plurality of logic gates or general-purpose microprocessor for processing various operations and configured as a single processor or a plurality of processors. For example, the controller 220 may be implemented in the form of at least one of a microprocessor, a CPU, a GPU, and an AP.

The controller 220 may operate together with a memory configured to store various pieces of data, commands, mobile applications, computer programs, etc. The memory may be configured separately from or integrally with the controller 220. The controller 220 may process various operations by executing commands stored in the memory. For example, the memory may be implemented as a non-volatile device such as a ROM, a PROM, an EPROM, an EEPROM, a flash memory, a PRAM, an MRAM, a RRAM, or an FRAM, or a volatile device such as a an SRAM, an SDRAM, or a PRAM, and implemented in the form of an HDD, an SSD, an SD, a Micro-SD, or a combination thereof.

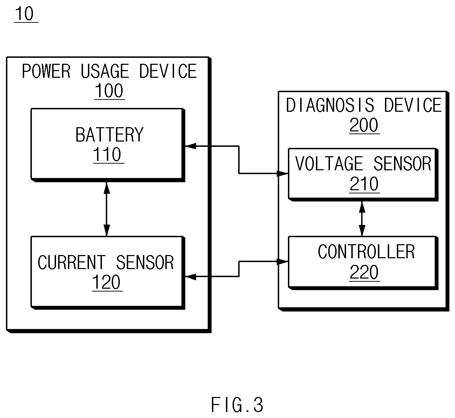

FIG. 3 may show a structure for diagnosing a state of a current sensor in the current sensor diagnosis system according to some embodiments.

Referring to FIG. 3, in the diagnosis system 10, the battery 110 and the current sensor 120 may be mounted in the power usage device 100. The power usage device 100 may use power provided by the battery 110.

The power usage device 100 may include a mobility device that obtains a driving force based on power provided by the battery 110. According to an embodiment, the mobility device may include an electric vehicle (EV), a hybrid electric vehicle (HEV), an electric bike, etc. The current sensor 120 may be mounted on the power usage device 100 and configured to be included in the diagnosis device 200 as needed.

The current sensor 120 may collect current data of the battery 110 and provide the same to the diagnosis device 200. On the other hand, voltage data of the battery 110 may be directly measured by the diagnosis device 200. As needed, the voltage sensor 210 may be provided in the power usage device 100 rather than the diagnosis device 200. According to an embodiment, the diagnosis device 200 may include a pack battery management system (BMS) device for managing the battery pack of the battery 110. Alternatively, the diagnosis device 200 may include a remote management server for wirelessly communicating with the power usage device 100.

The voltage sensor 210 may be configured to collect the voltage data from the battery 110. For example, the voltage sensor 220 may measure the pack voltage, module voltage, cell voltage, etc. of the battery 110 at a constant measurement cycle. The constant measurement cycle may be 250 ms and may be changed to another appropriate value as needed.

The controller 220 may be configured to determine whether a current flows in the battery 110 based on the current data of the battery 110 collected by the current sensor 120. The current data may include the pack current, module current, cell current, etc. of the battery 110. For example, when the pack current value of the battery 110 according to the current data is smaller than a current threshold value, it may be determined that no current flows in the battery 110. The current threshold value may be 0.1 A and may be changed to another appropriate value as needed.

When it is determined that no current flows in the battery 110 during a first time section, the controller 220 may be configured to specify a reference voltage at a first end time point of the first time section based on the voltage data. When a failure of the current sensor 120, such as an internal short, occurs, no current may flow in the battery 110. Meanwhile, the first time section may be used to check whether the absence of the current flowing in the battery 110 is due to a failure of the current sensor 120 or a temporary stop of charging and discharging of the battery 110. For example, when it is determined that a current re-flows in the battery 110 before the first time section elapses, it may be determined that the current sensor 120 does not fail. According to an embodiment, the first time section may be 10 seconds and changed to another appropriate value as needed. When the current value of the battery 110 is about zero until the first time section elapses, a voltage measured at the first end time point of the first time section may be specified as the reference voltage.

The controller 220 may be configured to diagnose the state of the current sensor 120 based on the reference voltage and voltage data after the first end time point. When an internal short of the current sensor 120 occurs, the current value of the battery 110 may be maintained as about zero until the first time section elapses. In addition, a specific pattern may appear in the voltage value of the battery 110 due to the internal short. Whether a failure has occurred in the current sensor 120 may be diagnosed based on whether the specific pattern of the voltage value appears after the first end time point. According to an embodiment, the specific pattern of the voltage value may include a spike pattern in which the voltage value changes rapidly for a short time.

According to an embodiment, the controller 220 may be configured to determine whether a current flows in the battery 110 after the first end time point based on current data and correct the state of the current sensor 120 based on whether a current flows in the battery 110 after the first end time point. When the current re-flows in the battery 110 after the first end time point, it can be interpreted that charging and discharging of the battery 110 is temporarily stopped, but when the current does not re-flow in the battery 110, it can be interpreted that a failure has occurred in the battery 110.

According to an embodiment, when it is determined that the current flows in the battery 110 after the first end time point, the controller 220 may be configured to determine that the charging or discharging of the battery 110 has been temporarily stopped during the first time section instead of diagnosing the state of the current sensor 120 as a failure. As described above, by using the first time section as a buffering section, a case where the temporary stop of charging and discharging is mistaken as a failure of the current sensor 120 can be prevented.

According to an embodiment, when it is determined that no current flows in the battery 110 during a second time section after the end time point, the controller 220 may be configured to specify a comparison voltage at a second end time point of the second time section and diagnose whether the current sensor 120 fails based on a difference between the reference voltage and the comparison voltage. To detect a spike pattern of the voltage of the battery 110 due to the internal short of the current sensor 120, the comparison voltage at the second end time point of the second time section may be compared with the reference voltage at the first end time point of the first time section. According to an embodiment, the first time section may be a section of 10 seconds, and the second time section may be a section of 1 second. In this case, the difference between the reference voltage and the comparison voltage at an interval of 1 second may be detected. Specific numerical values may be changed as needed.

According to an embodiment, the controller 220 may be configured to determine an additional voltage of the battery 110 in a measurement period immediately after the second end time point based on voltage data when the difference between the reference voltage and the comparison voltage exceeds the threshold value and to diagnose the state of the current sensor 110 as a failure when a difference between the additional voltage and the comparison voltage also exceeds the threshold value. For example, when the second time section is a one-second section, a failure of the current sensor 110 may be suspected when the difference between the reference voltage and the comparison voltage at an interval of 1 second exceeds the threshold value. To diagnose this more reliably, the additional voltage may be compared with the reference voltage. According to an embodiment, the measurement period of the current data and/or the voltage data may be 250 ms, and the measurement period immediately after the second end time point may be a time point 1.25 seconds after the first end time point. Therefore, the difference between the reference voltage and the additional voltage at an interval of 1.25 seconds may be analyzed through the comparison of the additional voltage. According to an embodiment, the threshold value may be 1300 mV, and the specific values may be changed as needed.

According to an embodiment, when the state of the current sensor 120 is diagnosed as a failure, the controller 220 may be further configured to inform a user of the battery 110 of the failure of the current sensor 120 and open a relay configured to open and close the connection of the battery 110. For example, the power usage device 100 provided with the battery 110 may be an electric bike, and a user of the electric bike may receive a message informing the failure of the current sensor 120 through his/her mobile terminal. In addition, a control command that opens a relay (e.g., a field effect transistor (FET)) connected between the battery 110 and a driving motor inside the power usage device 100 may be transmitted.

According to an embodiment, the battery 110 and the current sensor 120 may be mounted on a mobility device driven by electric energy, and the battery 110 may be charged or discharged by the mobility device. As described above, the power usage device 100 may include the mobility device, and the battery 110 may be discharged or charged by the motor driving and regenerative braking of the mobility device.

According to an embodiment, the current sensor 120 may include a shunt resistor sensor for measuring a current using a shunt resistor, and a failure of the current sensor 120 may include a failure that it is determined that a current does not flow in the battery 110 due to a short of the shunt resistor. For example, when the shunt resistor is shorted, voltages applied to both ends of the shunt resistor may become zero, and thus the shunt resistor sensor may determine that the current does not flow in the battery 110.

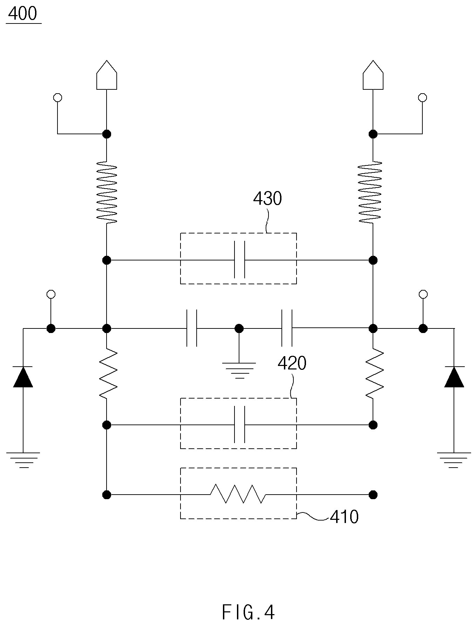

FIG. 4 may show a shunt resistor structure of the current sensor according to some embodiments.

Referring to FIG. 4, a current sensor 400 may include a shunt resistor sensor for measuring the current of the battery 110 using a shunt resistor 410.

The shunt resistor sensor may determine a value of the current flowing in the battery 110 using a voltage applied to the shunt resistor 410. Therefore, when the shunt resistor 410 is shorted, the voltages applied to both ends of the shunt resistor 410 may become zero, and even when the current flowing in the battery 110 is not zero, a measured value of the shunt resistor sensor may become zero.

The shunt resistor sensor may further include capacitors 420 and 430. An error may occur in the measured value of the shunt resistor sensor even when not only the shunt resistor 410 but also the capacitors 420 and 430 are shorted. Therefore, the shunt resistor 410 and the capacitors 420 and 430 may all be diagnosis targets of the current sensor diagnosis system 10.

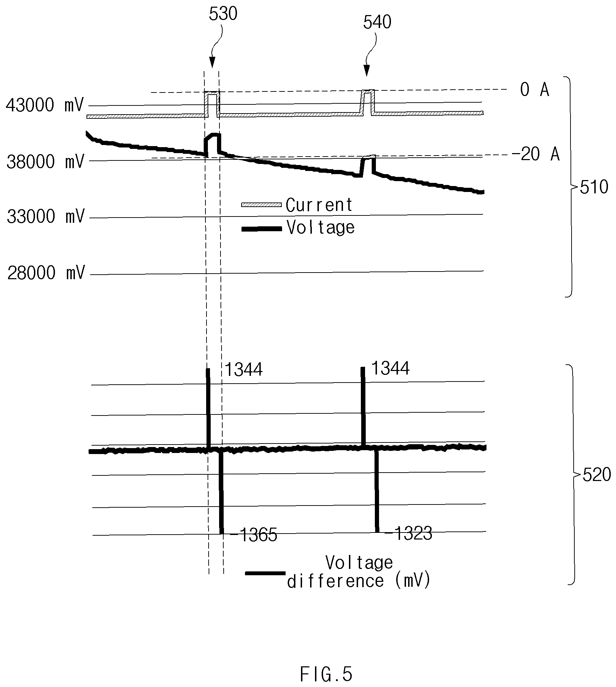

FIG. 5 may show an aspect in which a voltage value, a current value, and a voltage difference value are changed when a shunt resistor of the current sensor is shorted according to some embodiments.

Referring to FIG. 5, a graph 510 showing a battery current and a battery voltage when the battery 110 is discharged and a graph 520 showing a difference between the battery voltage and the reference voltage may be shown.

In the graph 510, the battery current may have a negative value because the battery 110 is being discharged. When internal shorts 530 and 540 of the current sensor 120 occur, the battery current may become zero even when the battery 110 is operating. When the battery current becomes zero, the battery voltage may also fluctuate significantly.

For example, in the graph 520, in the case of the internal short 530, a voltage difference exceeding 1300 mV may be observed at a time point when the battery current becomes zero. In addition, the voltage difference exceeding 1300 mV may be observed at the time point when the battery current recovers from zero to an original value. Using a specific voltage pattern of the graph 520, when the current value of the battery 110 becomes zero, whether this is due to a failure of the current sensor 120 or a temporary stop of the charging and discharging of the battery 110 may be distinguished. According to an embodiment, a threshold value used for comparison with the voltage difference value may be 1300 mV, and a specific value may vary depending on the capacity of the battery 110 or the standard of the power usage device 100.

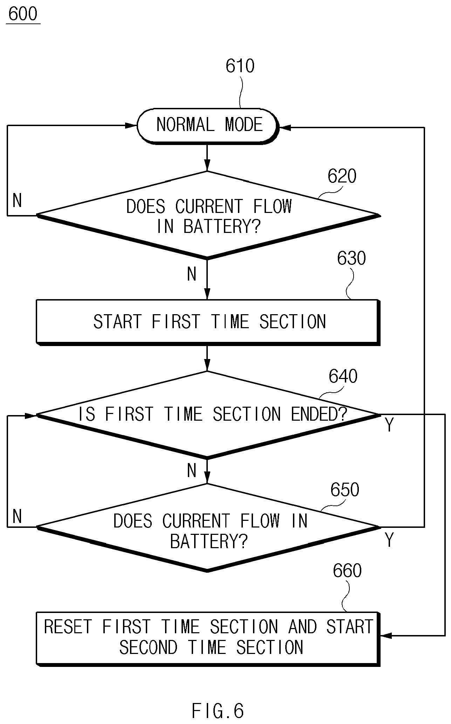

FIGS. 6 to 8 may show an algorithm for diagnosing a failure of the current sensor due to the short of the shunt resistor according to some embodiments.

Referring to FIG. 6, a first part 600 of an algorithm for diagnosing the failure of the current sensor 120 may be shown.

When it is determined that the current sensor 120 is in a normal mode rather than a short state in operation (610), it may be determined whether a current flows in the battery 110 in operation (620). In this case, it may be determined whether the current flows based on whether an absolute value of the current value flowing in the current sensor 120 exceeds a threshold value. The threshold value may be 0.1 A, and other values may be used as needed. According to an embodiment, the measurement cycle of the current sensor 120 may be 0.25 seconds, and it may be determined whether the current flows in the battery 110 every 0.25 seconds.

When it is determined that no current flows in the battery 110, the first time section may be started in operation (630). According to an embodiment, the first time section may be 10 seconds, and other values may be used as needed. In operations (640) and (650), it may be continuously checked whether the current flows in the battery 110 until the first time section elapses. It may be determined whether the current flows in the battery 110 whenever the current sensor 120 measures new current data (e.g., every 0.25 seconds). When it is determined that the current does not flow in the battery 110 until the first time section elapses, the second time section may be started, and the first time section may be ended and reset in operation (660).

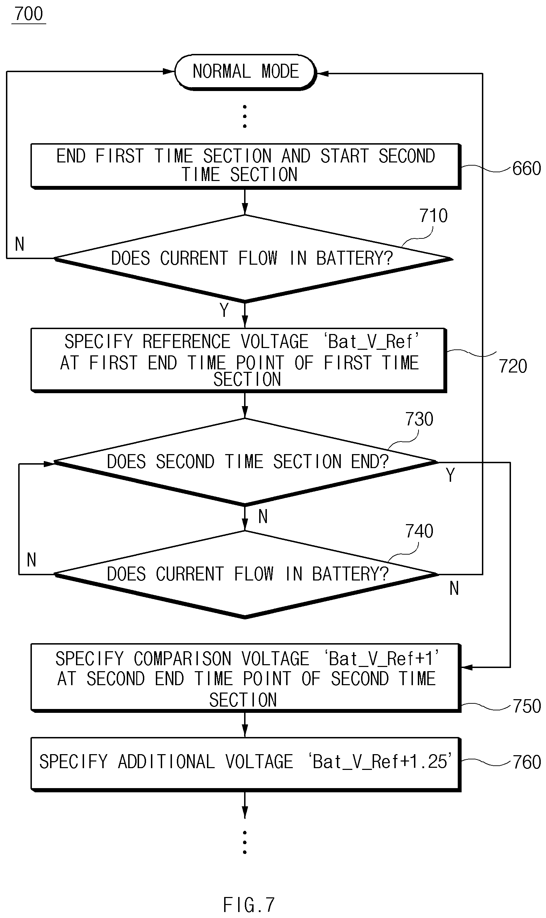

Referring to FIG. 7, a second part 700 of the algorithm for diagnosing the failure of the current sensor 120 may be shown.

When the first time section is reset and the second time section is started in operation (660), it may be determined whether the current flows in the battery 110 in operation (710). According to an embodiment, the second time section may be 1 seconds, or other values may be used as needed. Even in the second time section, whether the current flows may be determined based on whether the absolute value of the current flowing in the current sensor 120 exceeds a threshold value, and the threshold value may be 0.1 A. When it is determined that the current does not flow, a voltage of the battery 110 at a time point when the second time point is started may be specified as a reference voltage Bat_V_Ref in operation (720). According to an embodiment, the reference voltage Bat_V_Ref may be the voltage of the battery 110, which is measured at the first end time point of the first time section, that is, the time point when the second time section is started.

After the reference voltage Bat_V_Ref is specified, in operations (730, 740), whether the current flows in the battery 110 may be continuously checked until the second time section elapses. For example, when it is determined that no current flows in the battery 110 during the second time section of 1 second, a comparison voltage Bat_V_Ref+1 may be specified in operation (750). According to an embodiment, the comparison voltage Bat_V_Ref+1 may be the voltage of the battery 110, which is measured at the second end time point of the second time section. As described above, measurement cycles of various sensors may be 0.25 seconds, and when the first measurement cycle elapses after the second end time point, an additional voltage Bat_V_Ref+1.25 may be specified in operation (760).

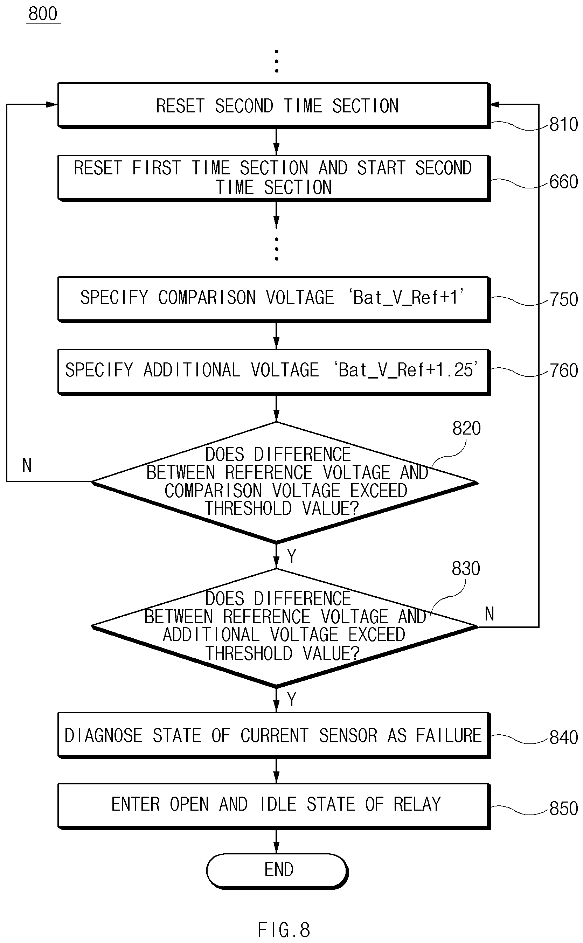

Referring to FIG. 8, a third part 800 of the algorithm for diagnosing the failure of the current sensor 120 may be shown.

When the comparison voltage Bat_V_Ref+1 and the additional voltage Bat_V_Ref+1.25 are specified in operations (750, 760), the comparison voltage Bat_V_Ref+1 and the additional voltage Bat_V_Ref+1.25 may be compared with the reference voltage Bat_V_Ref in operations (820, 830). According to an embodiment, a difference between the comparison voltage Bat_V_Ref+1 and the reference voltage Bat_V_Ref may be compared with the threshold value, and a difference between the additional voltage Bat_V_Ref+1.25 and the reference voltage Bat_V_Ref may be compared with the threshold value. The threshold value used for comparison with the reference voltage Bat_V_Ref may be 1300 mV, and other values may be used according to a change in design. For example, the specific meaning of the threshold value of 1300 mV can be confirmed through the graph 520 of FIG. 5. When the voltage difference does not exceed the threshold value in operation (820) or operation (830), the second time section may be reset in operation (810).

When the voltage difference exceeds the threshold value in operations (820, 830), the voltage data of the battery 110 may be interpreted as showing a specific pattern due to a short of the current sensor 120. In this case, the state of the current sensor 120 may be diagnosed as a failure state in operation (840), and to indicate this, a failure flag may be set from LOW to HIGH. When the failure flag is set to HIGH, a notification message regarding the failure of the current sensor 120 may be provided to the user of the battery 110. Additionally, in operation (860), the FET or the relay connected to the battery 110 may be opened to avoid being affected by the failure of the current sensor 120, and the battery 110 may enter an inactive mode.

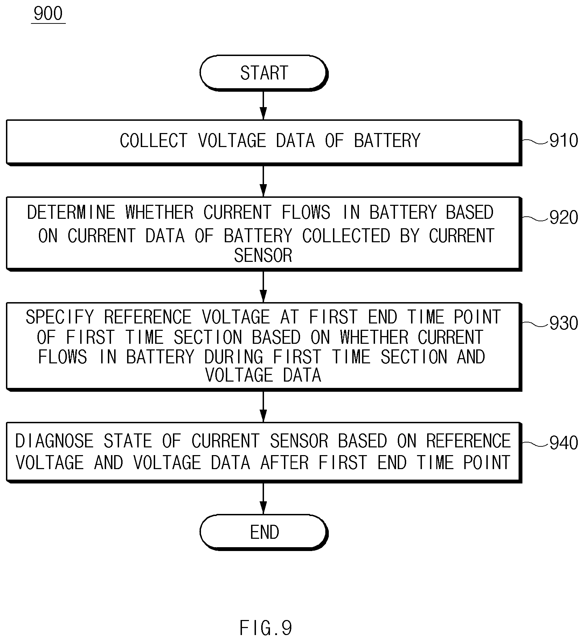

FIG. 9 may show operations constituting a current sensor diagnosing method according to some embodiments.

Referring to FIG. 9, a diagnosing method (900) may include operations (910 to 940). However, the embodiments are not limited thereto, and some operations may be omitted or general-purpose operations may be added, and operations of the diagnosing method (900) may be executed in a different order from the shown order.

The diagnosing method (900) may be composed of operations that are processed in time series in the diagnosis device 200. Therefore, even when contents are omitted below, the above-described contents for the diagnosis device 200 may be applied to the diagnosing method (900) in the same manner.

Operations (910 to 940) of the diagnostic method (900) may be performed by the voltage sensor 210 and the controller 220 of the diagnosis device 200.

In operation (910), the diagnosis device 200 may collect the voltage data of the battery. In operation (920), the diagnosis device 200 may determine whether the current flows in the battery based on the current data of the battery collected by the current sensor.

In operation (930), the diagnosis device 200 may specify the reference voltage at the first end time point of the first time section based on whether the current flows in the battery during the first time section and the voltage data. In operation (940), the diagnosis device 200 may diagnose the state of the current sensor based on the reference voltage and the voltage data after the first end time point.

According to an embodiment, the diagnosing method (900) may be implemented in the form of a computer program stored in a computer-readable storage medium. That is, the computer program may include commands for implementing the diagnosing method (900), and the commands of the program may be stored in the computer-readable storage medium. The computer program may include a mobile application.

According to an embodiment, the computer-readable recording medium may include magnetic media such as a hard disk, a floppy disk, and a magnetic tape, optical media such as a CD-ROM and a DVD, and magneto-optical media such as a floptical disk, and hardware devices specifically configured to store and execute program commands, such as a ROM, a RAM, and a flash memory. The computer program commands may include machine language code generated by a compiler and high-level language code that may be executed by a computer using an interpreter, etc.

The terms such as "comprise," "constitute," or "have" described above mean that the corresponding component may be inherent unless otherwise stated, and thus should be construed as further including another component rather than excluding another component. All terms including technical or scientific terms have the same meaning as commonly understood by those skilled in the art to which the embodiments disclosed herein pertain unless defined otherwise. Commonly used terms, such as terms defined in a dictionary, should be construed as consistent with the contextual meaning of the related art and are not construed in an ideal or excessively formal meaning unless explicitly defined herein.

The above description is merely the exemplary description of the technical spirit disclosed herein, and those skilled in the art to which embodiments disclosed herein pertain will be able to variously modify and change the present document without departing from the essential characteristics of the embodiments disclosed herein. Therefore, the embodiments disclosed herein are not intended to limit the technical spirit disclosed herein, but for illustrative purpose, and the scope of the technical spirit disclosed herein is not limited by these embodiments. The scope of the technical spirit disclosed herein should be construed by the appended claims, and all technical spirits within the equivalent range should be construed as being included in the scope of the present document.

### [DESCRIPTION OF REFERENCE NUMERALS]

| | | | |
|---|---|---|---|
| 10: | diagnosis system | 100: | power usage device |
| 110: | battery | 120: | current sensor |
| 200: | diagnosis device | 210: | voltage sensor |
| 220: | controller | | |

## Claims

1. A current sensor diagnosis device comprising:
a voltage sensor configured to collect voltage data of a battery; and
a controller configured to:
determine whether a current flows in the battery based on current data of the battery, which is collected by a current sensor;
specify a reference voltage at a first end time point of a first time section based on whether the current flows in the battery during the first time section and the voltage data; and
diagnose a state of the current sensor based on the reference voltage and the voltage data after the first end time point.

2. The current sensor diagnosis device of claim 1, wherein the controller is configured to:
determine whether the current flows in the battery after the first end time point based on the current data; and
correct the state of the current sensor based on whether the current flows in the battery after the first end time point.

3. The current sensor diagnosis device of claim 2, wherein, when it is determined that the current flows in the battery after the first end time point, the controller is configured to determine that charging or discharging of the battery has been temporarily stopped during the first time section.

4. The current sensor diagnosis device of claim 2, wherein the controller is configured to:
specify a comparison voltage at a second end time point of the second time section when it is determined that the current does not flow in the battery during a second time section after the end time point; and
diagnose whether the current sensor fails based on a difference between the reference voltage and the comparison voltage.

5. The current sensor diagnosis device of claim 4, wherein the controller is configured to:
specify an additional voltage of the battery at a measurement period immediately after the second end time point based on the voltage data when the difference between the reference voltage and the comparison voltage exceeds a threshold value; and
diagnose the state of the current sensor as a failure when a difference between the additional voltage and the comparison voltage exceeds the threshold value.

6. The current sensor diagnosis device of claim 1, wherein the controller is further configured to:
inform a user of the battery of a failure of the current sensor when the state of the current sensor is diagnosed as a failure; and
open a relay configured to open and close connection of the battery.

7. The current sensor diagnosis device of claim 1, wherein the battery and the current sensor are mounted on a mobility device driven using electrical energy, and
the battery is charged or discharged by the mobility device.

8. The current sensor diagnosis device of claim 1, wherein the current sensor includes a shunt resistor sensor configured to measure a current using a shunt resistor, and
a failure of the current sensor includes a failure that it is determined that the shunt resistor is shorted.

9. A current sensor diagnosing method comprising:
collecting voltage data of a battery;
determining whether a current flows in the battery based on current data of the battery, which is collected by a current sensor;
specifying a reference voltage at a first end time point of a first time section based on whether the current flows in the battery during a first time section and the voltage data; and
diagnosing a state of the current sensor based on the reference voltage and the voltage data after the first end time point.

10. The current sensor diagnosing method of claim 9, wherein the diagnosing of the state of the current sensor includes:
determining whether the current flows in the battery after the first end time point based on the current data; and
correcting the state of the current sensor based on whether the current flows in the battery after the first end time point.

11. The current sensor diagnosing method of claim 10, wherein the correcting of the state of the current sensor includes determining that charging or discharging of the battery has been temporarily stopped during the first time section when it is determined that the current flows in the battery after the first end time point.

12. The current sensor diagnosing method of claim 10, wherein the diagnosing of the state of the current sensor includes:
specifying a comparison voltage at a second end time point of the second time section when it is determined that the current does not flow in the battery during a second time section after the end time point; and
diagnosing whether the current sensor fails based on a difference between the reference voltage and the comparison voltage.

13. The current sensor diagnosing method of claim 12, wherein the diagnosing of the state of the current sensor includes:
specifying an additional voltage of the battery at a measurement period immediately after the second end time point based on the voltage data when the difference between the reference voltage and the comparison voltage exceeds a threshold value; and
diagnosing the state of the current sensor as a failure when a difference between the additional voltage and the comparison voltage exceeds the threshold value.

14. The current sensor diagnosing method of claim 9, further comprising:
informing a user of the battery of a failure of the current sensor when the state of the current sensor is diagnosed as a failure; and
opening a relay configured to open and close connection of the battery.

15. The current sensor diagnosing method of claim 9, wherein the battery and the current sensor are mounted on a mobility device driven using electrical energy, and
the battery is charged or discharged by the mobility device.

16. The current sensor diagnosing method of claim 9, wherein the current sensor includes a shunt resistor sensor configured to measure a current using a shunt resistor, and
a failure of the current sensor includes a failure that it is determined that the shunt resistor is shorted.

17. A current sensor diagnosis system comprising:
a battery;
a current sensor configured to collect current data of the battery; and
a current sensor diagnosis device configured to collect voltage data of the battery, determine whether a current flows in the battery based on the current data, specify a reference voltage at a first end time point of a first time section based on whether the current flows in the battery during the first time section and the voltage data, and diagnose a state of the current sensor based on the reference voltage and the voltage data after the first end time point.

18. The current sensor diagnosis system of claim 17, wherein the current sensor diagnosis device is configured to:
determine whether the current flows in the battery after the first end time point based on the current data; and
correct the state of the current sensor based on whether the current flows in the battery after the first end time point.

19. The current sensor diagnosis system of claim 18, wherein, when it is determined that the current flows in the battery after the first end time point, the current sensor diagnosis device is configured to determine that charging or discharging of the battery has been temporarily stopped during the first time section.

20. The current sensor diagnosis system of claim 18, wherein the current sensor diagnosis device is configured to:
specify a comparison voltage at a second end time point of the second time section when it is determined that the current does not flow in the battery during a second time section after the end time point; and
diagnose whether the current sensor fails based on a difference between the reference voltage and the comparison voltage.
